(19) Europäisches Patentamt
European Patent Office
Office européen des brevets

(11) EP 3 451 398 A1

(12) EUROPEAN PATENT APPLICATION

(43) Date of publication:
06.03.2019 Bulletin 2019/10

(51) Int Cl.:
H01L 49/02 (2006.01)     H03F 3/45 (2006.01)
H03F 1/32 (2006.01)

(21) Application number: 18177526.3

(22) Date of filing: 13.06.2018

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 01.09.2017  US 201715693548
09.11.2017  US 201762583576 P
16.04.2018  US 201815953772

(71) Applicant: MediaTek Inc.
Hsin-chu 300 (TW)

(72) Inventors:
• WEN, Sung-Han
Taipei City 103 (TW)
• CHEN, Kuan-Ta
Hsinchu City 300 (TW)

(74) Representative: Wright, Howard Hugh Burnby
Withers & Rogers LLP
4 More London Riverside
London SE1 2AU (GB)

(54) IMPEDANCE CIRCUIT WITH POLY-RESISTOR

(57) An impedance circuit includes a first poly-resistor and a second poly-resistor. The first poly-resistor has a first terminal coupled to a first node, and a second terminal coupled to a second node. The second poly-resistor has a first terminal coupled to the first node, and a second terminal coupled to the second node. The resistance between the first terminal and the second terminal of the first poly-resistor is determined according to a first control voltage. The resistance between the first terminal and the second terminal of the second poly-resistor is determined according to a second control voltage. The first control voltage and the second control voltage are determined according to a first voltage at the first node and a second voltage at the second node.

FIG. 2

**Description**

Field of the Invention

The disclosure generally relates to an impedance circuit, and more specifically, to an impedance circuit and poly-resistors therein.

**Description of the Related Art**

Poly-resistors are characterized by their sheet resistance values. In order to reduce the chip size, the poly-resistors with high sheet resistance values are often used and fabricated in a small area, and they are extensively used in a variety of integrated circuits.

However, the depletion effect is a phenomenon in which there is unwanted variation in the threshold voltage of devices using poly-silicon as a gate material, leading to unpredictable behavior on the part of electronic circuits. It results in serious non-linearity of the poly-resistors. Accordingly, there is a need for a novel solution for suppressing the non-ideal depletion effect in poly-resistors.

**BRIEF SUMMARY OF THE INVENTION**

In a preferred embodiment, the invention is directed to an impedance circuit including a first poly-resistor and a second poly-resistor. The first poly-resistor has a first terminal coupled to a first node, and a second terminal coupled to a second node. The second poly-resistor has a first terminal coupled to the first node, and a second terminal coupled to the second node. A resistance between the first terminal and the second terminal of the first poly-resistor is determined according to a first control voltage. A resistance between the first terminal and the second terminal of the second poly-resistor is determined according to a second control voltage. The first control voltage and the second control voltage are determined according to a first voltage at the first node and a second voltage at the second node.

In some embodiments, each of the first control voltage and the second control voltage is a linear function of the first voltage and the second voltage.

In some embodiments, the first control voltage is substantially equal to the first voltage, and the second control voltage is substantially equal to the second voltage.

In some embodiments, the first poly-resistor includes a first poly-silicon layer, a first channel layer, and a first insulation layer. The first poly-silicon layer has a first end and a second end. The first end of the first poly-silicon layer is coupled to the first node, and the second end of the first poly-silicon layer is coupled to the second node. The first channel layer has a first end and a second end. The first end of the first channel layer is arranged for receiving the first control voltage. The first insulation layer is disposed between the first poly-silicon layer and the first channel layer.

In some embodiments, the first end of the first channel layer is close to the first end of the first poly-silicon layer, and the second end of the first channel layer is close to the second end of the first poly-silicon layer.

In some embodiments, the second poly-resistor includes a second poly-silicon layer, a second channel layer, and a second insulation layer. The second poly-silicon layer has a first end and a second end. The first end of the second poly-silicon layer is coupled to the first node, and the second end of the second poly-silicon layer is coupled to the second node. The second channel layer has a first end and a second end. The second end of the second channel layer is arranged for receiving the second control voltage. The second insulation layer is disposed between the second poly-silicon layer and the second channel layer.

In some embodiments, the first end of the second channel layer is close to the first end of the second poly-silicon layer, and the second end of the second channel layer is close to the second end of the second poly-silicon layer.

In some embodiments, each of the first channel layer and the second channel layer is a conductive layer, a semiconductor layer, or another poly-silicon layer.

In some embodiments, each of the first insulation layer and the second insulation layer is a silicon dioxide layer, a field oxide (FOX) layer, or a shallow trench isolation (STI) layer.

In some embodiments, the impedance circuit further includes a third poly-resistor and a fourth poly-resistor. The third poly-resistor has a first terminal coupled to the second node, and a second terminal coupled to a third node. The fourth poly-resistor has a first terminal coupled to the second node, and a second terminal coupled to the third node. A resistance between the first terminal and the second terminal of the third poly-resistor is determined according to a third control voltage. A resistance between the first terminal and the second terminal of the fourth poly-resistor is determined according to a fourth control voltage. The third control voltage and the fourth control voltage are determined according to the second voltage at the second node and a third voltage at the third node.

In some embodiments, each of the third control voltage and the fourth control voltage is a linear function of the second voltage and the third voltage.

In some embodiments, the third control voltage is substantially equal to the second voltage, and the fourth control voltage is substantially equal to the third voltage.

In some embodiments, the impedance circuit is a feedback resistor.

In some embodiments, the impedance circuit is a common-mode feedback resistor.

In some embodiments, the impedance circuit is used in a differential or a pseudo-differential amplifier.

In some embodiments, the impedance circuit is used in a differential-to-single-ended amplifier.

In some embodiments, the impedance circuit is used in an inverting amplifier.

In another preferred embodiment, the invention is directed to an impedance circuit including a first poly-resistor, a second poly-resistor, a third poly-resistor, and a fourth poly-resistor. The first poly-resistor has a first terminal coupled to a first node, and a second terminal coupled to a second node. The second poly-resistor has a first terminal coupled to the first node, and a second terminal coupled to a third node. The third poly-resistor has a first terminal coupled to the second node, and a second terminal coupled to a fourth node. The fourth poly-resistor has a first terminal coupled to the third node, and a second terminal coupled to the fourth node. A resistance between the first terminal and the second terminal of the first poly-resistor is determined according to a first control voltage. A resistance between the first terminal and the second terminal of the second poly-resistor is determined according to a second control voltage. A resistance between the first terminal and the second terminal of the third poly-resistor is determined according to a third control voltage. A resistance between the first terminal and the second terminal of the fourth poly-resistor is determined according to a fourth control voltage. The first control voltage, the second control voltage, the third control voltage, and the fourth control voltage are determined according to a first voltage at the first node, a second voltage at the second node, a third voltage at the third node, and a fourth voltage at the fourth node.

In some embodiments, each of the first control voltage, the second control voltage, the third control voltage, and the fourth control voltage is a linear function of the first voltage, the second voltage, the third voltage, and the fourth voltage.

In some embodiments, the first control voltage is substantially equal to the first voltage, the second control voltage is substantially equal to the third voltage, the third control voltage is substantially equal to the second voltage, and the fourth control voltage is substantially equal to the fourth voltage.

## BRIEF DESCRIPTION OF DRAWINGS

The invention can be more fully understood by reading the subsequent detailed description and examples with references made to the accompanying drawings, wherein:

FIG. 1 is a diagram of an impedance circuit according to an embodiment of the invention;
FIG. 2 is a diagram of a poly-resistor according to an embodiment of the invention;
FIG. 3 is a diagram of a poly-resistor according to an embodiment of the invention;
FIG. 4 is a diagram of a poly-resistor according to an embodiment of the invention;
FIG. 5A is a diagram of an impedance circuit according to an embodiment of the invention;
FIG. 5B is a diagram of an impedance circuit according to another embodiment of the invention;
FIG. 6A is a diagram of a differential or pseudo-differential amplifier according to an embodiment of the invention;
FIG. 6B is a diagram of a differential or pseudo-differential amplifier according to an embodiment of the invention;
FIG. 6C is a diagram of a differential or pseudo-differential amplifier according to an embodiment of the invention;
FIG. 6D is a diagram of a differential or pseudo-differential amplifier according to an embodiment of the invention;
FIG. 7A is a diagram of a differential-to-single-ended amplifier according to an embodiment of the invention;
FIG. 7B is a diagram of a differential-to-single-ended amplifier according to an embodiment of the invention;
FIG. 7C is a diagram of a differential-to-single-ended amplifier according to an embodiment of the invention;
FIG. 7D is a diagram of a differential-to-single-ended amplifier according to an embodiment of the invention;
FIG. 8A is a diagram of an inverting amplifier according to an embodiment of the invention;
FIG. 8B is a diagram of an inverting amplifier according to an embodiment of the invention;
FIG. 8C is a diagram of an inverting amplifier according to an embodiment of the invention;
FIG. 9 is a diagram of an impedance circuit according to another embodiment of the invention;
FIG. 10 is a diagram of an impedance circuit according to another embodiment of the invention;
FIG. 11 is a diagram of an impedance circuit according to another embodiment of the invention; and
FIG. 12 is a diagram of an impedance circuit according to another embodiment of the invention.

## DETAILED DESCRIPTION OF THE INVENTION

In order to illustrate the purposes, features and advantages of the invention, the embodiments and figures of the invention will be described in detail as follows.

Certain terms are used throughout the description and following claims to refer to particular components. As one skilled in the art will appreciate, manufacturers may refer to a component by different names. This document does not intend to distinguish between components that differ in name but not function. In the following description and in the claims, the terms "include" and "comprise" are used in an open-ended fashion, and thus should be interpreted to mean "include, but not limited to... ". The term "substantially" means the value is within an acceptable error range. One skilled in the art can solve the technical problem within a predetermined error range and achieve the proposed technical performance. Also, the term "couple" is intended to mean either an indirect or direct electrical connection. Accordingly, if one device is coupled to another device, that connection may be through a direct electrical connection, or through an indirect electrical connection via other devices and connections.

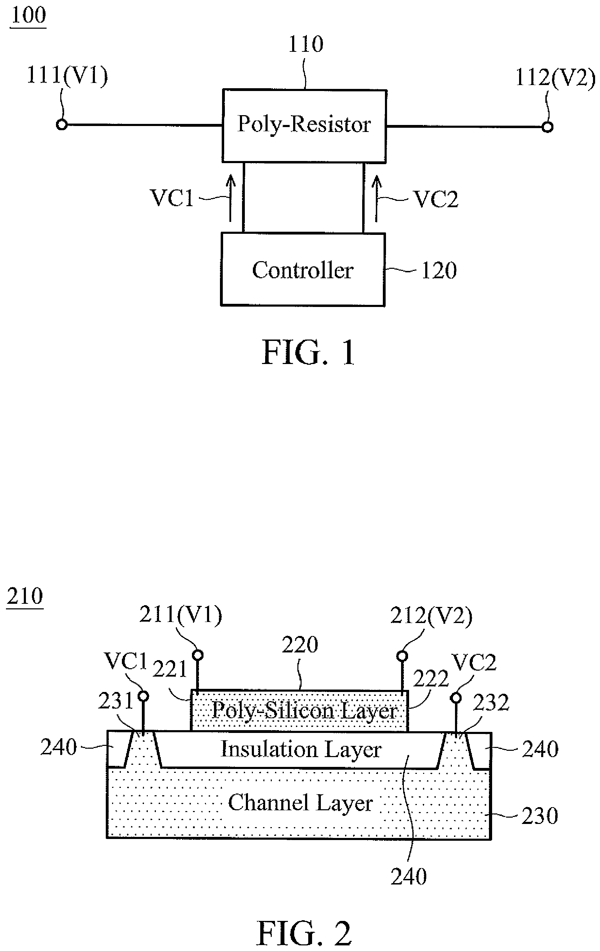

FIG. 1 is a diagram of an impedance circuit 100 according to an embodiment of the invention. The impedance circuit 100 includes a poly-resistor 110 and a controller 120. The poly-resistor 110 has a first terminal 111 and a second terminal 112. If a second voltage V2 at the second terminal 112 is higher than a first voltage V1 at the first terminal 111 (i.e., a driving voltage difference (V2-V1) is applied to the poly-resistor 110), a current through the poly-resistor 110 will flow from the second terminal 112 to the first terminal 111. The controller 120 may be a voltage generator, a voltage divider, or a weighted summer circuit. The controller 120 is configured to generate a first control voltage VC1 and a second control voltage VC2 for controlling the poly-resistor 110. The resistance between the first terminal 111 and the second terminal 112 of the poly-resistor 110 is determined according to the first control voltage VC1 and the second control voltage VC2. In one embodiment, the second control voltage VC2 is different from the first control voltage VC1.

Such a design can improve the linearity of the poly-resistor 110. Please refer to the following embodiments and figures. It should be noted that these embodiments and figures are exemplary, rather than restricted limitations of the invention.

FIG. 2 is a diagram of a poly-resistor 210 according to an embodiment of the invention. FIG. 2 illustrates the detailed physical structure of the poly-resistor 110 of FIG. 1. In FIG. 2, the poly-resistor 210 with a first terminal 211 and a second terminal 212 includes a poly-silicon layer 220, a channel layer 230 and an insulation layer 240. The poly-silicon layer 220 has a first end 221 and a second end 222, which are located apart from each other. The first end 221 of the poly-silicon layer 220 is coupled to the first terminal 211 of the poly-resistor 210, and the second end 222 of the poly-silicon layer 220 is coupled to the second terminal 212 of the poly-resistor 210. If a second voltage V2 at the second terminal 212 is higher than a first voltage V1 at the first terminal 211 (i.e., a driving voltage difference (V2-V1) is applied to the poly-resistor 210), a current through the poly-resistor 210 will flow from the second terminal 212 to the first terminal 211. That is, the current may flow through the poly-silicon layer 220, from the second end 222 to the first end 221. The channel layer 230 may be a conductive layer, a semiconductor layer, or another poly-silicon layer which is different from the poly-silicon layer 220. The channel layer 230 has a first end 231 and a second end 232, which are located apart from each other. The first end 231 of the channel layer 230 is arranged for receiving the first control voltage VC1, and the second end 232 of the channel layer 230 is arranged for receiving the second control voltage VC2. In some embodiments, the first end 231 of the channel layer 230 is closer to the first end 221 of the poly-silicon layer 220 than to the second end 232 of the channel layer 230, and the second end 232 of the channel layer 230 is closer to the second end 222 of the poly-silicon layer 220 than to the first end 231 of the channel layer 230. As a result, the first control voltage VC1 controls the operation characteristic (e.g., the resistance) of the first end 221 of the poly-silicon layer 220, and the second control voltage VC2 controls the operation characteristic (e.g., the resistance) of the second end 222 of the poly-silicon layer 220. The insulation layer 240 may be made of any nonconductive material. The insulation layer 240 is disposed between the poly-silicon layer 220 and the channel layer 230, and is configured to isolate the poly-silicon layer 220 from the channel layer 230.

Please refer to FIG. 1 further in view of FIG. 2 and understand the operation theory of the invention. To suppress the depletion effect of the poly-resistor 110, the first control voltage VC1 and the second control voltage VC2 may be dynamic, instead of being constant values. For example, the first control voltage VC1 and the second control voltage VC2 may be determined according to the first voltage V1 at the first terminal 111 of the poly-resistor 110, and the second voltage V2 at the second terminal 112 of the poly-resistor 110. That is, each of the first control voltage VC1 and the second control voltage VC2 may be a function of the first voltage V1 and the second voltage V2. The aforementioned functions may be linear and expressed as the following equations (1) to (3):

$$VC1 = f(V1, V2) = A \cdot V1 + B \cdot V2 \quad \dots\dots\dots\dots\dots\dots\dots\dots\dots\dots\dots\dots(1)$$

$$VC2 = g(V1, V2) = C \cdot V1 + D \cdot V2 \dots\dots\dots\dots\dots\dots\dots\dots\dots\dots\dots\dots(2)$$

$$VC2 \neq VC1 \quad \ldots\ldots\ldots\ldots\ldots\ldots\ldots\ldots\ldots\ldots\ldots\ldots\ldots\ldots\ldots\ldots\ldots\ldots\ldots\ldots\ldots\ldots\ldots..(3)$$

where "VC1" represents the first control voltage VC1, "VC2" represents the second control voltage VC2, "V1" represents the first voltage V1, "V2" represents the second voltage V2, and each of "A", "B", "C", and "D" represents a respective value.

The above values A, B, C, and D are adjustable in response to different requirements. Specifically, when the controller 120 dynamically adjusts the first control voltage VC1 and the second control voltage VC2 in response to the first voltage V1 and the second voltage V2, the depletion effect of the poly-resistor 110 can be suppressed. The proposed impedance circuit is more linear and more concentrated than the conventional poly-resistor in which only one control voltage is applied to the poly-resistor, or the control voltage applied to the poly-resistor is fixed.

In some embodiments, the first control voltage VC1 is substantially equal to the first voltage V1, and the second control voltage VC2 is substantially equal to the second voltage V2. That is, according to the equations (1) to (3), the values A and D are both set to 1, and the values B and C are both set to 0. Please refer to the physical structure of FIG. 2. If the first control voltage VC1 is equal to the first voltage V1 and the second control voltage VC2 is equal to the second voltage V2, the control voltage difference (e.g., VC2-VC1) between the second control voltage VC2 and the first control voltage VC1 will be the same as the driving voltage difference (e.g.,V2-V1) between the second terminal 212 and the first terminal 211 of the poly-resistor 210. The control voltage difference (e.g., VC2-VC1) is uniformly distributed over the channel layer 230, and it is consistent with the driving voltage difference (e.g.,V2-V1) which is uniformly distributed over the poly-silicon layer 220. With such a design, the channel layer 230 has almost the same voltage level distribution as that of the poly-silicon layer 220, and no effective voltage difference exists between the channel layer 230 and the poly-silicon layer 220. Therefore, compared with the conventional method applying only one control voltage, the depletion effect of the poly-resistor 210 can be eliminated, and the poly-resistor 210 can provide resistance to accomplish better and more concentrated linearity.

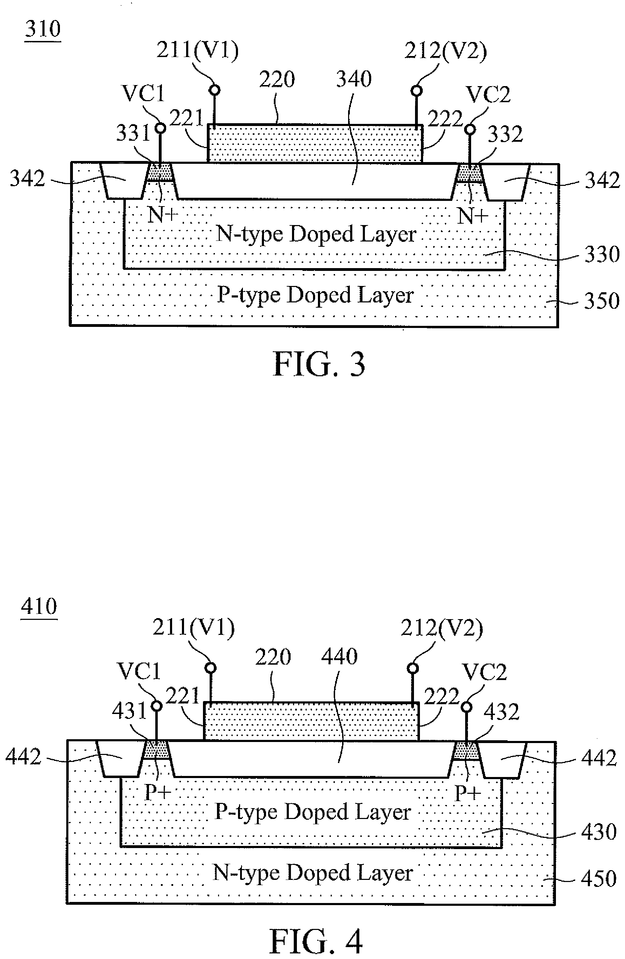

FIG. 3 is a diagram of a poly-resistor 310 according to an embodiment of the invention. FIG. 3 is similar to FIG. 2. In the embodiment of FIG. 3, a channel layer 330 of the poly-resistor 310 is an N-type doped layer, which may be configured in a P-type doped layer 350, and a first end 331 and a second end 332 of the channel layer 330 are n+ doped regions. An insulation layer 340 of the poly-resistor 310 can be of different materials, such as a silicon dioxide layer, a field oxide (FOX) layer, or a Shallow Trench Isolation (STI) layer, but is not limited thereto. Other features of the poly-resistor 310 of FIG. 3 are similar to those of the poly-resistor 210 of FIG. 2. FIG. 4 is a diagram of a poly-resistor 410 according to an embodiment of the invention. FIG. 4 is similar to FIG. 2. In the embodiment of FIG. 4, a channel layer 430 of the poly-resistor 410 is a P-type doped layer, which may be configured in an N-type doped layer 450, and a first end 431 and a second end 432 of the channel layer 430 are p+ doped regions. An insulation layer 440 can be of different materials, such as a silicon dioxide layer, a field oxide (FOX) layer, or a STI layer, but is not limited thereto. Other features of the poly-resistor 410 of FIG. 4 are similar to those of the poly-resistor 210 of FIG. 2.

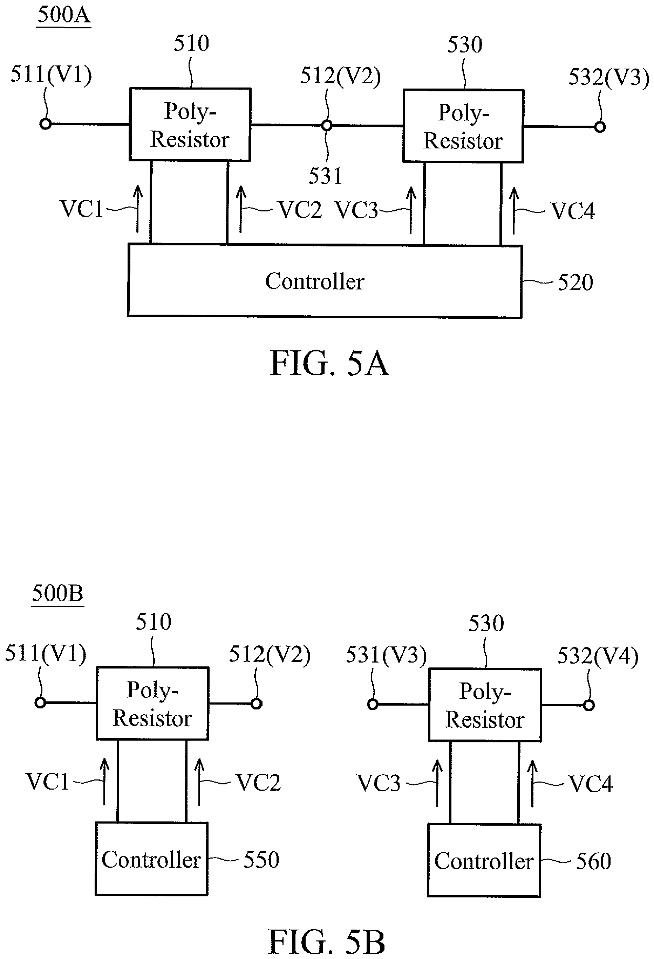

FIG. 5A is a diagram of an impedance circuit 500A according to an embodiment of the invention. FIG. 5A is similar to FIG. 1. In the embodiment of FIG. 5A, the impedance circuit 500A includes a first poly-resistor 510, a second poly-resistor 530, and a controller 520. The first poly-resistor 510 has a first terminal 511 and a second terminal 512. The second poly-resistor 530 has a first terminal 531 and a second terminal 532. The first terminal 531 of the second poly-resistor 530 is coupled to the second terminal 512 of the first poly-resistor 510. The controller 520 is configured to generate a first control voltage VC1, a second control voltage VC2, a third control voltage VC3, and a fourth control voltage VC4 for controlling the first poly-resistor 510 and the second poly-resistor 530. The resistance between the first terminal 511 and the second terminal 512 of the first poly-resistor 510 is determined according to the first control voltage VC1 and the second control voltage VC2. In one embodiment, the second control voltage VC2 is different from the first control voltage VC1. The resistance between the first terminal 531 and the second terminal 532 of the second poly-resistor 530 is determined according to the third control voltage VC3 and the fourth control voltage VC4. In one embodiment, the fourth control voltage VC4 is different from the third control voltage VC3.

In the impedance circuit 500A, a first poly-resistor 510 and a second poly-resistor 530 are coupled in series. The first control voltage VC1, the second control voltage VC2, the third control voltage VC3 and the fourth control voltage VC4 may be dynamic. The first control voltage VC1 and the second control voltage VC2 may be determined according to a first voltage V1 at the first terminal 511 of the first poly-resistor 510, and a second voltage V2 at the second terminal 512 of the first poly-resistor 510. Each of the first control voltage VC1 and the second control voltage VC2 may be a function of the first voltage V1 and the second voltage V2. The aforementioned function may be linear. For example, the first control voltage VC1 may be substantially equal to the first voltage V1, and the second control voltage VC2 may be substantially equal to the second voltage V2, but they are not limited thereto. The third control voltage VC3 and the fourth control voltage VC4 may be determined according to the second voltage V2 at the first terminal 531 of the second poly-resistor 530, and a third voltage V3 at the second terminal 532 of the second poly-resistor 530. Each of the third control voltage VC3 and the fourth control voltage VC4 may be a function of the second voltage V2 and the third voltage V3. The aforementioned function may be linear. For example, the third control voltage VC3 may be substantially equal to the second voltage V2, and the fourth control voltage VC4 may be substantially equal to the third voltage V3, but they are not limited thereto. Other features of the impedance circuit 500A of FIG. 5A are similar to those of the impedance circuit 100 of FIG. 1. Accordingly, the two embodiments can achieve similar levels of performance. It should be noted that the impedance circuit 500A may include three or more poly-resistors which are coupled in series and controlled by the controller in a similar way although there are only two poly-resistors displayed in FIG. 5A.

FIG. 5B is a diagram of an impedance circuit 500B according to another embodiment of the invention. FIG. 5B is similar to FIG. 5A. In the embodiment of FIG. 5B, the impedance circuit 500B further includes a first controller 550 and a second controller 560. Such a design can also suppress the non-linear depletion effect. The first controller 550 is configured to generate the first control voltage VC1 and the second control voltage VC2 for controlling the first poly-resistor 510. The second controller 560 is configured to generate the third control voltage VC3 and the fourth control voltage VC4 for controlling the second poly-resistor 530. Similarly, the first control voltage VC1, the second control voltage VC2, the third control voltage VC3, and the fourth control voltage VC4 may be dynamic. In the impedance circuit 500B, the second poly-resistor 530 is separate from the first poly-resistor 510. The first control voltage VC1 and the second control voltage VC2 may be determined according to a first voltage V1 at the first terminal 511 of the first poly-resistor 510, and a second voltage V2 at the second terminal 512 of the first poly-resistor 510. Each of the first control voltage VC1 and the second control voltage VC2 may be a function of the first voltage V1 and the second voltage V2. The aforementioned function may be linear. For example, the first control voltage VC1 may be substantially equal to the first voltage V1, and the second control voltage VC2 may be substantially equal to the second voltage V2, but they are not limited thereto. The third control voltage VC3 and the fourth control voltage VC4 may be determined according to a third voltage V3 at the first terminal 531 of the second poly-resistor 530, and a fourth voltage V4 at the second terminal 532 of the second poly-resistor 530. Each of the third control voltage VC3 and the fourth control voltage VC4 may be a function of the third voltage V3 and the fourth voltage V4. The aforementioned function may be linear. For example, the third control voltage VC3 may be substantially equal to the third voltage V3, and the fourth control voltage VC4 may be substantially equal to the fourth voltage V4, but they are not limited thereto. Other features of the impedance circuit 500B of FIG. 5B are similar to those of the impedance circuit 500A of FIG. 5A. It should be noted that the impedance circuit 500B may include three or even more poly-resistors which are respectively controlled by three or more controllers in a similar way.

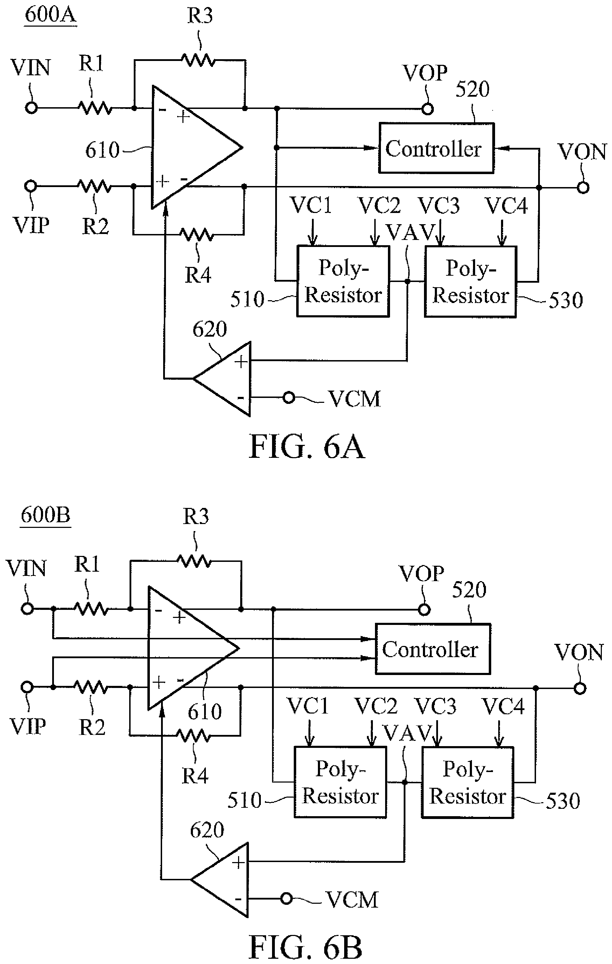

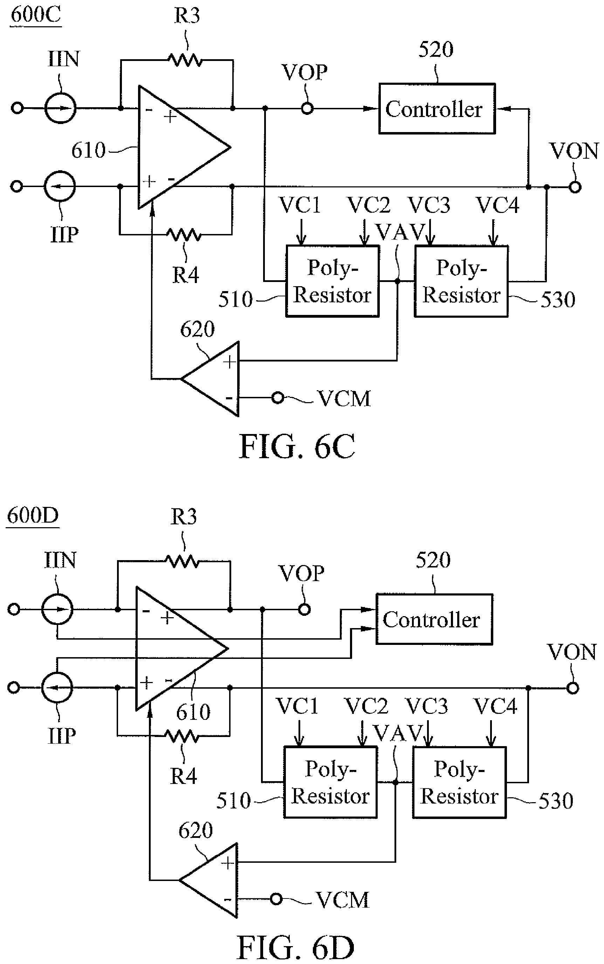

The proposed impedance circuit and the poly-resistor therein can be applied to a variety of circuits. Please refer to the following embodiments in FIGS. 6-8.

FIG. 6A is a diagram of a differential or pseudo-differential amplifier 600A according to an embodiment of the invention. In the embodiment of FIG. 6A, the differential or pseudo-differential amplifier 600A generates a positive output voltage VOP and a negative output voltage VON according to a positive input voltage VIP and a negative input voltage VIN. For example, the positive output voltage VOP and the negative output voltage VON may have different electrical characteristic, such as different current driving capabilities, different output signal swings, or different frequency responses. Specifically, the differential or pseudo-differential amplifier 600A includes a main operational amplifier 610, an auxiliary operational amplifier 620, a first resistor R1, a second resistor R2, a third resistor R3, a fourth resistor R4, a controller 520, a first poly-resistor 510, and a second poly-resistor 530. The first resistor R1 is coupled between the negative input voltage VIN and a negative input terminal of the main operational amplifier 610. The second resistor R2 is coupled between the positive input voltage VIP and a positive input terminal of the main operational amplifier 610. The third resistor R3 is coupled between the negative input terminal and a positive output terminal (i.e., the positive output voltage VOP) of the main operational amplifier 610. The fourth resistor R4 is coupled between the positive input terminal and a negative output terminal (i.e., the negative output voltage VON) of the main operational amplifier 610. An inner voltage VAV is between the first poly-resistor 510 and the second resistor 530, and it may be close to a common voltage VCM. The first poly-resistor 510 is coupled between the positive output terminal (i.e., the positive output voltage VOP) of the main operational amplifier 610 and the inner voltage VAV. The second poly-resistor 530 is coupled between the inner voltage VAV and the negative output terminal (i.e., the negative output voltage VON) of the main operational amplifier 610. The auxiliary operational amplifier 620 compares the inner voltage VAV with the common voltage VCM, so as to adjust the output common-mode voltage (VCMO) of the main operational amplifier 610 with a negative feedback mechanism. The common voltage VCM may be set to a ground voltage VSS (e.g., 0V). The controller 520 is configured to generate a first control voltage VC1 and a second control voltage VC2 for controlling the first poly-resistor 510, and further generate a third control voltage VC3 and a fourth control voltage VC4 for controlling the second poly-resistor 530. In some embodiments, the first control voltage VC1, the second control voltage VC2, the third control voltage VC3, and the fourth control voltage VC4 are determined according to the positive output voltage VOP, the negative output voltage VON, and the inner voltage VAV. Specifically, each of the first control signal VC1 and the second control signal VC2 may be dynamic and be a function of the positive output voltage VOP and the inner voltage VAV; and each of the third control signal VC3 and the fourth control signal VC4 may be dynamic and be a function of the inner voltage VAV and the negative output voltage VON. For example, the first control voltage VC1 may be substantially equal to the positive output voltage VOP, the second control voltage VC2 and the third control voltage VC3 may be both substantially equal to the inner voltage VAV, and the fourth control voltage VC4 may be substantially equal to the negative output voltage VON, but they are not limited thereto. In the embodiment of FIG. 6A, each of the first poly-resistor 510 and the second poly-resistor 530 is a common-mode feedback resistor used in the differential or pseudo-differential amplifier 600A.

FIG. 6B is a diagram of a differential or pseudo-differential amplifier 600B according to an embodiment of the invention. FIG. 6B is similar to FIG. 6A. In the embodiment of FIG. 6B, the controller 520 controls the first poly-resistor 510 and the second resistor 530 according to the positive input voltage VIP and the negative input voltage VIN, which are related to the positive output voltage VOP and the negative output voltage VON. FIG. 6C is a diagram of a differential or pseudo-differential amplifier 600C according to an embodiment of the invention. FIG. 6C is similar to FIG. 6A. In the embodiment of FIG. 6C, the differential or pseudo-differential amplifier 600C generates the positive output voltage VOP and the negative output voltage VON according to a positive input current IIP and a negative input current IIN. FIG. 6D is a diagram of a differential or pseudo-differential amplifier 600D according to an embodiment of the invention. FIG. 6D is similar to FIG. 6C. In the embodiment of FIG. 6D, the controller 520 controls the first poly-resistor 510 and the second resistor 530 according to the positive input current IIP and the negative input current IIN, which are related to the positive output voltage VOP and the negative output voltage VON. Other features of the differential or pseudo-differential amplifiers 600B, 600C, and 600D of FIGS. 6B, 6C, and 6D are similar to those of the differential or pseudo-differential amplifier 600A of FIG. 6A. Accordingly, these embodiments can achieve similar levels of performance.

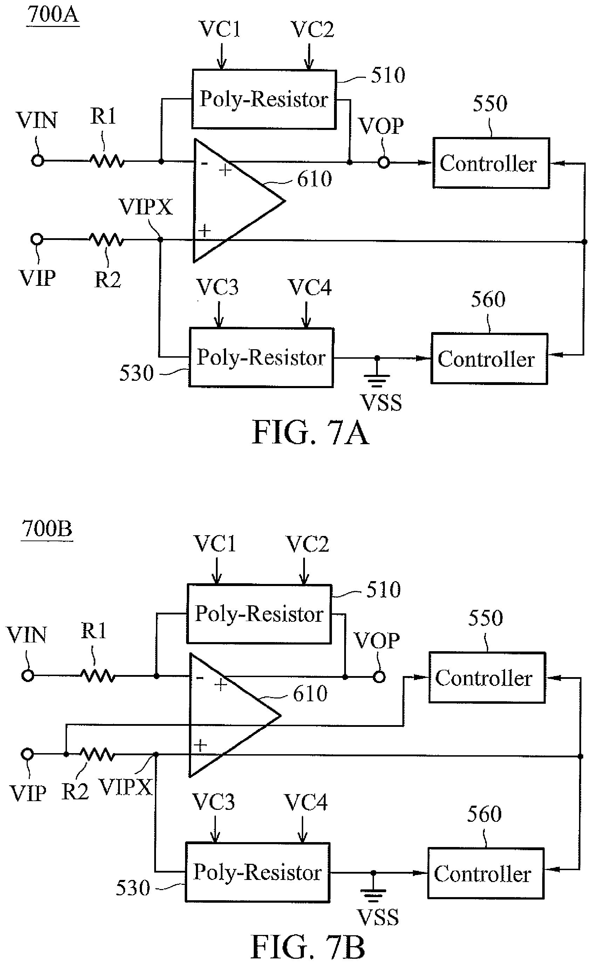

FIG. 7A is a diagram of a differential-to-single-ended amplifier 700A according to an embodiment of the invention. In the embodiment of FIG. 7A, the differential-to-single-ended amplifier 700A generates a positive output voltage VOP according to a positive input voltage VIP and a negative input voltage VIN. Specifically, the differential-to-single-ended amplifier 700A includes a main operational amplifier 610, a first resistor R1, a second resistor R2, a first poly-resistor 510, a second poly-resistor 530, a first controller 550, and a second controller 560. The first resistor R1 is coupled between the negative input voltage VIN and a negative input terminal of the main operational amplifier 610. The second resistor R2 is coupled between the positive input voltage VIP and a positive input terminal of the main operational amplifier 610. A positive inner voltage VIPX is at the positive input terminal of the main operational amplifier 610. The first poly-resistor 510 is coupled between the negative input terminal and a positive output terminal (i.e., the positive output voltage VOP) of the main operational amplifier 610. The second poly-resistor 530 is coupled between the positive input terminal of the main operational amplifier 610 and a ground voltage VSS. The first controller 550 is configured to generate a first control voltage VC1 and a second control voltage VC2 for controlling the first poly-resistor 510. The second controller 560 is configured to generate a third control voltage VC3 and a fourth control voltage VC4 for controlling the second poly-resistor 530. In some embodiments, the first control voltage VC1, the second control voltage VC2, the third control voltage VC3, and the fourth control voltage VC4 are determined according to the positive output voltage VOP, the positive inner voltage VIPX, and the ground voltage VSS. Specifically, each of the first control signal VC1 and the second control signal VC2 may be dynamic and be a function of the positive inner voltage VIPX and the positive output voltage VOP; and each of the third control signal VC3 and the fourth control signal VC4 may be dynamic and be a function of the positive inner voltage VIPX and the ground voltage VSS. For example, the first control voltage VC1 and the third control voltage VC3 may be substantially equal to the positive inner voltage VIPX, the second control voltage VC2 may be substantially equal to the positive output voltage VOP, and the fourth control voltage VC4 may be substantially equal to the ground voltage VSS, but they are not limited thereto. In the embodiment of FIG. 7A, each of the first poly-resistor 510 and the second poly-resistor 530 is a feedback resistor used in the differential-to-single-ended amplifier 700A.

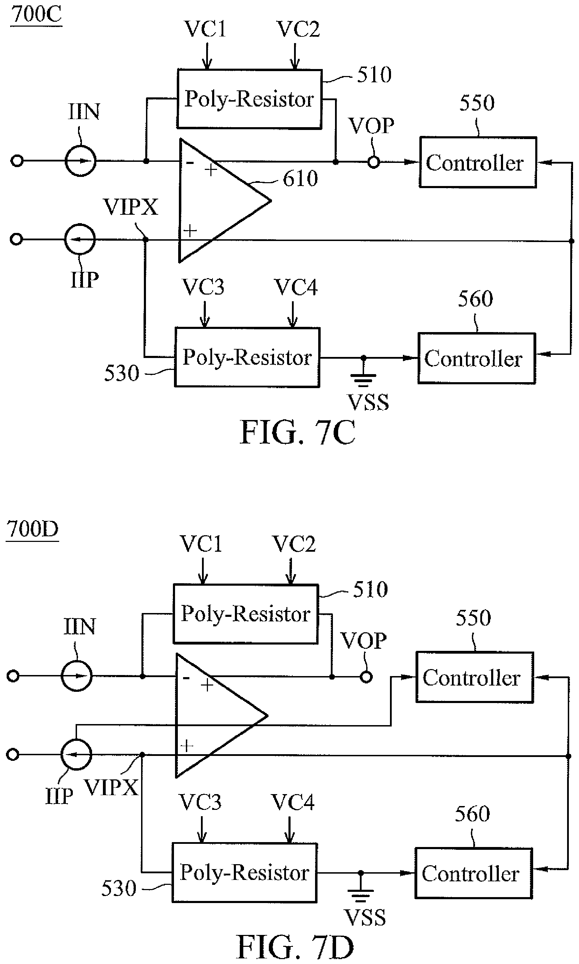

FIG. 7B is a diagram of a differential-to-single-ended amplifier 700B according to an embodiment of the invention. FIG. 7B is similar to FIG. 7A. In the embodiment of FIG. 7B, the first controller 550 controls the first poly-resistor 510 according to the positive input voltage VIP, which is related to the positive output voltage VOP. FIG. 7C is a diagram of a differential-to-single-ended amplifier 700C according to an embodiment of the invention. FIG. 7C is similar to FIG. 7A. In the embodiment of FIG. 7C, the differential-to-single-ended amplifier 700C generates the positive output voltage VOP according to a positive input current IIP and a negative input current IIN FIG. 7D is a diagram of a differential-to-single-ended amplifier 700D according to an embodiment of the invention. FIG. 7D is similar to FIG. 7C. In the embodiment of FIG. 7D, the first controller 550 controls the first poly-resistor 510 according to the positive input current IIP, which is related to the positive output voltage VOP. Other features of the differential-to-single-ended amplifiers 700B, 700C, and 700D of FIGS. 7B, 7C, and 7D are similar to those of the differential-to-single-ended amplifier 700A of FIG. 7A. Accordingly, these embodiments can achieve similar levels of performance.

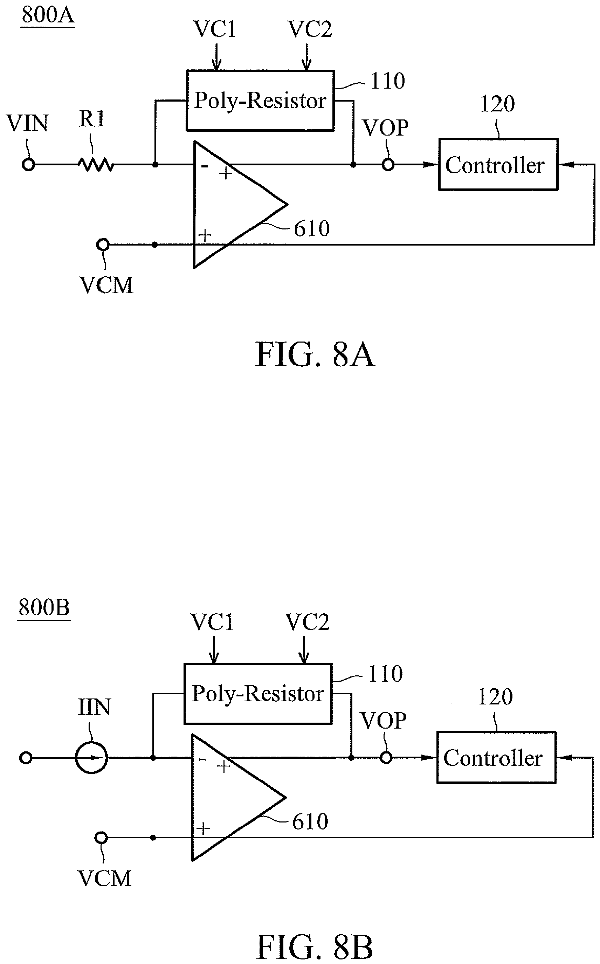

FIG. 8A is a diagram of an inverting amplifier 800A according to an embodiment of the invention. In the embodiment of FIG. 8A, the inverting amplifier 800A generates a positive output voltage VOP according to a negative input voltage VIN. Specifically, the inverting amplifier 800A includes a main operational amplifier 610, a first resistor R1, a controller 120, and a poly-resistor 110. The first resistor R1 is coupled between the negative input voltage VIN and a negative input terminal of the main operational amplifier 610. A common voltage VCM is at a positive input terminal of the main operational amplifier 610. The common voltage VCM may be set to a ground voltage VSS (e.g., 0V). The poly-resistor 110 is coupled between the negative input terminal and a positive output terminal (i.e., the positive output voltage VOP) of the main operational amplifier 610. The controller 120 is configured to generate a first control voltage VC1 and a second control voltage VC2 for controlling the poly-resistor 110. In some embodiments, the first control voltage VC1 and the second control voltage VC2 are determined according to the positive output voltage VOP and the common voltage VCM. Specifically, each of the first control signal VC1 and the second control signal VC2 may be dynamic and be a function of the positive output voltage VOP and the common voltage VCM. For example, the first control voltage VC1 may be substantially equal to the common voltage VCM, and the second control voltage VC2 may be substantially equal to the positive output voltage VOP, but they are not limited thereto. In the embodiment of FIG. 8A, the poly-resistor 110 is a feedback resistor used in the inverting amplifier 800A.

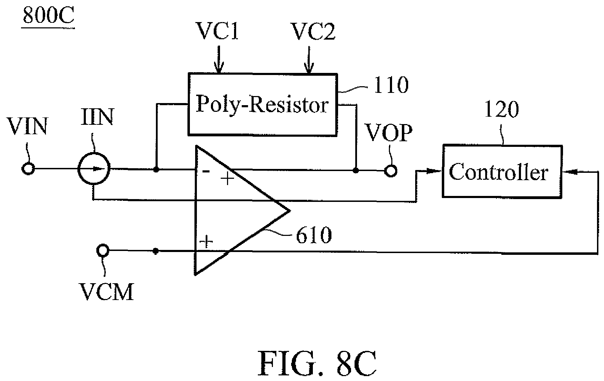

FIG. 8B is a diagram of an inverting amplifier 800B according to an embodiment of the invention. FIG. 8B is similar to FIG. 8A. In the embodiment of FIG. 8B, the inverting amplifier 800B generates the positive output voltage VOP according to a negative input current IIN. FIG. 8C is a diagram of an inverting amplifier 800C according to an embodiment of the invention. FIG. 8C is similar to FIG. 8B. In the embodiment of FIG. 8C, the controller 120 controls the poly-resistor 110 according to the positive input current IIN, which is related to the positive output voltage VOP. Other features of the inverting amplifiers 800B and 800C of FIGS. 8B and FIG. 8C are similar to those of the inverting amplifier 800A of FIG. 8A. Accordingly, these embodiments can achieve similar levels of performance.

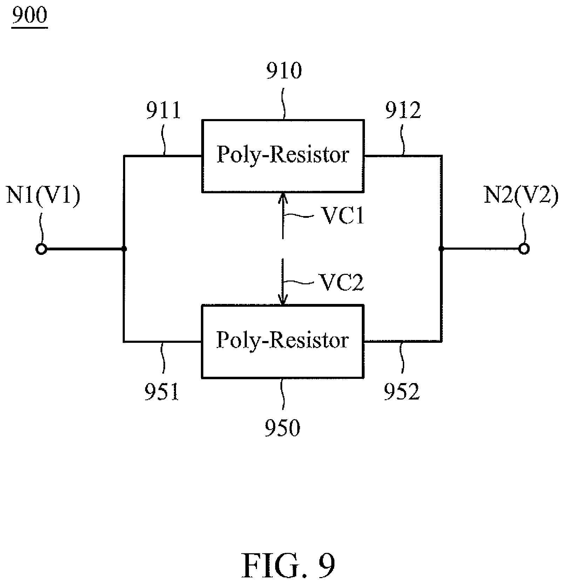

FIG. 9 is a diagram of an impedance circuit 900 according to another embodiment of the invention. The impedance circuit 900 includes a first poly-resistor 910 and a second poly-resistor 950. In some embodiments, the first poly-resistor 910 and the second poly-resistor 950 have identical structures. In alternative embodiments, the first poly-resistor 910 and the second poly-resistor 950 have different structures but the same resistances. The first poly-resistor 910 has a first terminal 911 and a second terminal 912. The second poly-resistor 950 has a first terminal 951 and a second terminal 952. The first poly-resistor 910 and the second poly-resistor 950 are coupled in parallel. Specifically, the first terminal 911 of the first poly-resistor 910 and the first terminal 951 of the second poly-resistor 950 are both coupled to a first node N1; the second terminal 912 of the first poly-resistor 910 and the second terminal 952 of the second poly-resistor 950 are both coupled to a second node N2. The first node N1 and the second node N2 may be considered as I/O (Input/Output) nodes of the impedance circuit 900. If a second voltage V2 at the second node N2 is higher than a first voltage V1 at the first node N1 (i.e., a driving voltage difference (V2-V1) is applied to the impedance circuit 900), a current through the first poly-resistor 910 and the second poly-resistor 950 will flow from the second node N2 to the first node N1. The resistance between the first terminal 911 and the second terminal 912 of the first poly-resistor 910 is determined according to a first control voltage VC1. The resistance between the first terminal 951 and the second terminal 952 of the second poly-resistor 950 is determined according to a second control voltage VC2. In one embodiment, the second control voltage VC2 is different from the first control voltage VC1. The first control voltage VC1 and the second control voltage VC2 are determined according to the first voltage V1 at the first node N1 and the second voltage V2 at the second node N2.

In some embodiments, the first control voltage VC1 and the second control voltage VC2 are generated by a controller (not shown), but they are not limited thereto. The controller may be a voltage generator, a voltage divider, or a weighted summer circuit. In alternative embodiments, any of the first control voltage VC1 and the second control voltage VC2 is tied together with the first voltage V1 or the second voltage V2, and no controller is required.

With respect to the operation theory, the first poly-resistor 910 may induce a positive depletion effect or a positive resistance variation, and the second poly-resistor 950 may induce a negative depletion effect or a negative resistance variation. When the first poly-resistor 910 and the second poly-resistor 950 are coupled in parallel, the positive depletion effect will be cancelled by the negative depletion effect. Accordingly, such a design can improve the linearity of the impedance circuit 900. Please refer to the following embodiments and figures. It should be noted that these embodiments and figures are exemplary, rather than restricted limitations of the invention.

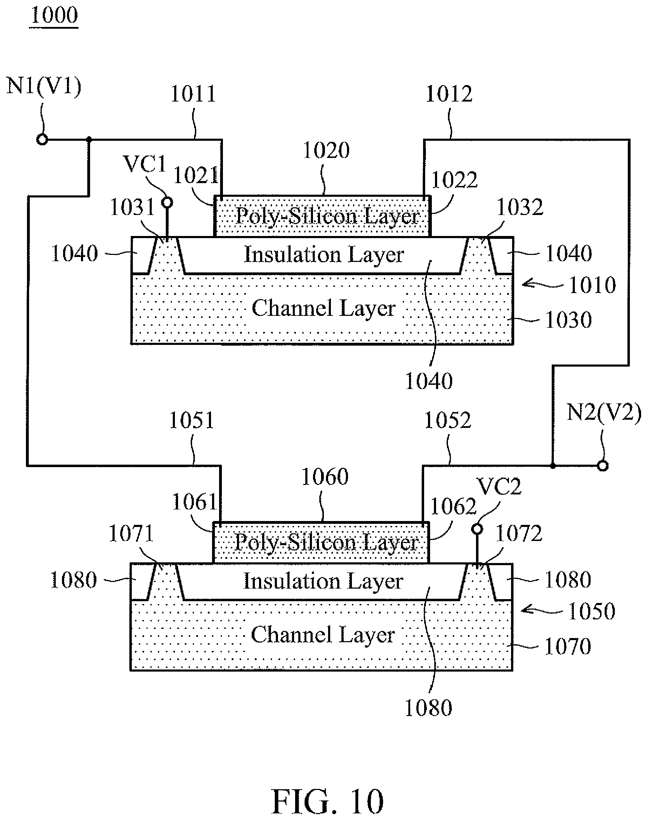

FIG. 10 is a diagram of an impedance circuit 1000 according to another embodiment of the invention. FIG. 10 illustrates the detailed physical structure of the impedance circuit 900 of FIG. 9. The impedance circuit 1000 includes a first poly-resistor 1010 and a second poly-resistor 1050, which are coupled in parallel. In some embodiments, the first poly-resistor 1010 and the second poly-resistor 1050 have identical structures. In alternative embodiments, the first poly-resistor 1010 and the second poly-resistor 1050 have different structures but the same resistances. As shown in FIG. 10, the first poly-resistor 1010 with a first terminal 1011 and a second terminal 1012 includes a first poly-silicon layer 1020, a first channel layer 1030, and a first insulation layer 1040. The first poly-silicon layer 1020 has a first end 1021 and a second end 1022, which are located apart from each other. The first end 1021 of the first poly-silicon layer 1020 is coupled to a first node N1 (i.e., the first terminal 1011 of the first poly-resistor 1010). The second end 1022 of the first poly-silicon layer 1020 is coupled to a second node N2 (i.e., the second terminal 1012 of the first poly-resistor 1010). The first channel layer 1030 may be a conductive layer, a semiconductor layer, or another poly-silicon layer which is different from the first poly-silicon layer 1020. The first channel layer 1030 can have has a first end 1031 and a second end 1032, which are located apart from each other. The first end 1031 of the first channel layer 1030 is arranged for receiving a first control voltage VC1. In some embodiments, the first end 1031 of the first channel layer 1030 is closer to the first end 1021 of the first poly-silicon layer 1020 than to the second end 1032 of the first channel layer 1030; the second end 1032 of the first channel layer 1030 is closer to the second end 1022 of the first poly-silicon layer 1020 than to the first end 1031 of the first channel layer 1030. The first insulation layer 1040 may be made of any nonconductive material. The first insulation layer 1040 is disposed between the first poly-silicon layer 1020 and the first channel layer 1030, and is configured to isolate the first poly-silicon layer 1020 from the first channel layer 1030.

Similarly, the second poly-resistor 1050 with a first terminal 1051 and a second terminal 1052 includes a second poly-silicon layer 1060, a second channel layer 1070, and a second insulation layer 1080. The second poly-silicon layer 1060 has a first end 1061 and a second end 1062, which are located apart from each other. The first end 1061 of the second poly-silicon layer 1060 is coupled to the first node N1 (i.e., the first terminal 1051 of the second poly-resistor 1050). The second end 1062 of the second poly-silicon layer 1060 is coupled to the second node N2 (i.e., the second terminal 1052 of the second poly-resistor 1050). The second channel layer 1070 may be a conductive layer, a semiconductor layer, or another poly-silicon layer which is different from the second poly-silicon layer 1060. The second channel layer 1070 has a first end 1071 and a second end 1072, which are located apart from each other. The second end 1072 of the second channel layer 1070 is arranged for receiving a second control voltage VC2. In some embodiments, the first end 1071 of the second channel layer 1070 is closer to the first end 1061 of the second poly-silicon layer 1060 than to the second end 1072 of the second channel layer 1070; the second end 1072 of the second channel layer 1070 is closer to the second end 1062 of the second poly-silicon layer 1060 than to the first end 1071 of the second channel layer 1070. The second insulation layer 1080 may be made of any nonconductive material. The second insulation layer 1080 is disposed between the second poly-silicon layer 1060 and the second channel layer 1070, and is configured to isolate the second poly-silicon layer 1060 from the second channel layer 1070.

In some embodiments, each of the first poly-resistor 1010 and the second poly-resistor 1050 includes the same doped layers and doped regions as described in FIG. 3 and FIG. 4. As mentioned above, each of the first insulation layer 1040 and the second insulation layer 1080 may be a silicon dioxide layer, a field oxide (FOX) layer, or a shallow trench isolation (STI) layer.

If a second voltage V2 at the second node N2 is higher than a first voltage V1 at the first node N1 (i.e., a driving voltage difference (V2-V1) is applied to the impedance circuit 1000), a current through the first poly-resistor 1010 and the second poly-resistor 1050 will flow from the second node N2 to the first node N1. The current may flow through the first poly-silicon layer 1020, from the second end 1022 to the first end 1021. Also, the current may flow through the second poly-silicon layer 1060, from the second end 1062 to the first end 1061. As a result, the first control voltage VC1 controls the operation characteristic (e.g., the resistance) of the first poly-silicon layer 1020, and the second control voltage VC2 controls the operation characteristic (e.g., the resistance) of the second poly-silicon layer 1060.

Please refer to FIG. 9 further in view of FIG. 10 and understand the operation theory of the invention. To suppress the depletion effect of the first poly-resistor 910 and the second poly-resistor 950, besides the parallel connection of poly-resistors, the first control voltage VC1 and the second control voltage VC2 should be determined according to the first voltage V1 at the first node N1 and the second voltage V2 at the second node N2. That is, each of the first control voltage VC1 and the second control voltage VC2 may be a function of the first voltage V1 and the second voltage V2. The aforementioned functions may be linear and expressed as the following equations (4) and (5):

$$ VC1 = h1(V1, V2) = E \cdot V1 + F \cdot V2 \dots\dots\dots\dots\dots\dots\dots\dots\dots\dots\dots\dots(4) $$

$$ VC2 = k1(V1, V2) = G \cdot V1 + H \cdot V2 \dots\dots\dots\dots\dots\dots\dots\dots\dots\dots\dots\dots(5) $$

where "VC1" represents the first control voltage VC1, "VC2" represents the second control voltage VC2, "V1" represents the first voltage V1, "V2" represents the second voltage V2, and each of "E", "F", "G", and "H" represents a respective value.

The above values E, F, G, and H are adjustable in response to different requirements. In some embodiments, the first control voltage VC1 is substantially equal to the first voltage V1, and the second control voltage VC2 is substantially equal to the second voltage V2. That is, according to the equations (4) and (5), the values E and H are both set to 1, and the values F and G are both set to 0. Please refer to the physical structure of FIG. 10. If the first control voltage VC1 is equal to the first voltage V1 and the second control voltage VC2 is equal to the second voltage V2, the (positive) depletion effect on the first poly-silicon layer 1020 will be cancelled by the (negative) depletion effect on the second poly-silicon layer 1060. With such a design, the (positive) resistance variation in the first poly-silicon layer 1020 can be cancelled by the (negative) resistance variation in the second poly-silicon layer 1060. Therefore, the depletion effect of the impedance circuit 900 can be eliminated, and the impedance circuit 900 can provide resistance to accomplish better and more concentrated linearity.

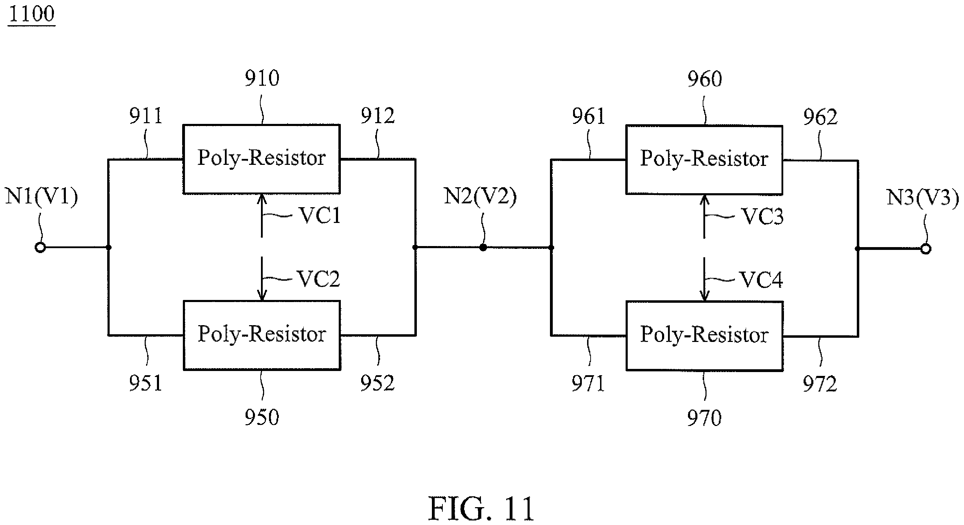

FIG. 11 is a diagram of an impedance circuit 1100 according to another embodiment of the invention. FIG. 11 is similar to FIG. 9. In the embodiment of FIG. 11, besides the first poly-resistor 910 and the second poly-resistor 950, the impedance circuit 1100 further includes a third poly-resistor 960 and a fourth poly-resistor 970. In some embodiments, the third poly-resistor 960 and the fourth poly-resistor 970 have identical structures. In alternative embodiments, the third poly-resistor 960 and the fourth poly-resistor 970 have different structures but the same resistances. The third poly-resistor 960 has a first terminal 961 and a second terminal 962. The fourth poly-resistor 970 has a first terminal 971 and a second terminal 972. The third poly-resistor 960 and the fourth poly-resistor 970 are coupled in parallel. Specifically, the first terminal 961 of the third poly-resistor 960 and the first terminal 971 of the fourth poly-resistor 970 are both coupled to the second node N2; the second terminal 962 of the third poly-resistor 960 and the second terminal 972 of the fourth poly-resistor 970 are both coupled to a third node N3. The first node N1 and the third node N3 may be considered as I/O (Input/Output) nodes of the impedance circuit 1100. If a third voltage V3 at the third node N3 is higher than a first voltage V1 at the first node N1 (i.e., a driving voltage difference (V3-V1) is applied to the impedance circuit 1100), a current through the first poly-resistor 910, the second poly-resistor 950, the third poly-resistor 960, and the fourth poly-resistor 970 will flow from the third node N3 to the first node N1. The resistance between the first terminal 961 and the second terminal 962 of the third poly-resistor 960 is determined according to a third control voltage VC3. The resistance between the first terminal 971 and the second terminal 972 of the fourth poly-resistor 970 is determined according to a fourth control voltage VC4. In one embodiment, the fourth control voltage VC4 is different from the third control voltage VC3. The third control voltage VC3 and the fourth control voltage VC4 are determined according to the second voltage V2 at the second node N2 and the third voltage V3 at the third node N3. In some embodiments, each of the first poly-resistor 910, the second poly resistor 950, the third poly-resistor 960, and the fourth poly-resistor 970 includes a similar physical structure to that described in the embodiment of FIG. 3, FIG. 4, or FIG. 10, and it will not be illustrated again here.

In some embodiments, each of the third control voltage VC3 and the fourth control voltage VC4 may be a function of the second voltage V2 and the third voltage V3. The aforementioned functions may be linear and expressed as the following equations (6) and (7):

$$VC3 = h2(V2, V3) = K \cdot V2 + L \cdot V3 \dots\dots\dots\dots\dots\dots\dots\dots\dots\dots\dots\dots(6)$$

$$VC4 = k2(V2, V3) = M \cdot V2 + N \cdot V3 \dots\dots\dots\dots\dots\dots\dots\dots\dots\dots\dots(7)$$

where "VC3" represents the third control voltage VC3, "VC4" represents the fourth control voltage VC4, "V2" represents the second voltage V2, "V3" represents the third voltage V3, and each of "K", "L", "M", and "N" represents a respective value.

The above values K, L, M, and N are adjustable in response to different requirements. In some embodiments, the third control voltage VC3 is substantially equal to the second voltage V2, and the fourth control voltage VC4 is substantially equal to the third voltage V3. That is, according to the equations (6) and (7), the values K and N are both set to 1, and the values L and M are both set to 0.

In alternative embodiments, each of the first control voltage V1, the second control voltage V2, the third control voltage VC3, and the fourth control voltage VC4 may be a linear function of the first voltage V1 and the third voltage V3. The third voltage V2 may be represented by a linear combination of the first voltage V1 and the third voltage V3. That is, for equations (4) and (5), each variable value "V2" may be replaced with another variable value "V3", which represents the third voltage V3; for equations (6) and (7), each variable value "V2" may be replaced with another variable value "V1", which represents the first voltage V1. Other features of the impedance circuit 1100 of FIG. 11 are similar to those of the impedance circuits 900 and 1000 of FIGS. 9 and 10. Accordingly, these embodiments can achieve similar levels of performance.

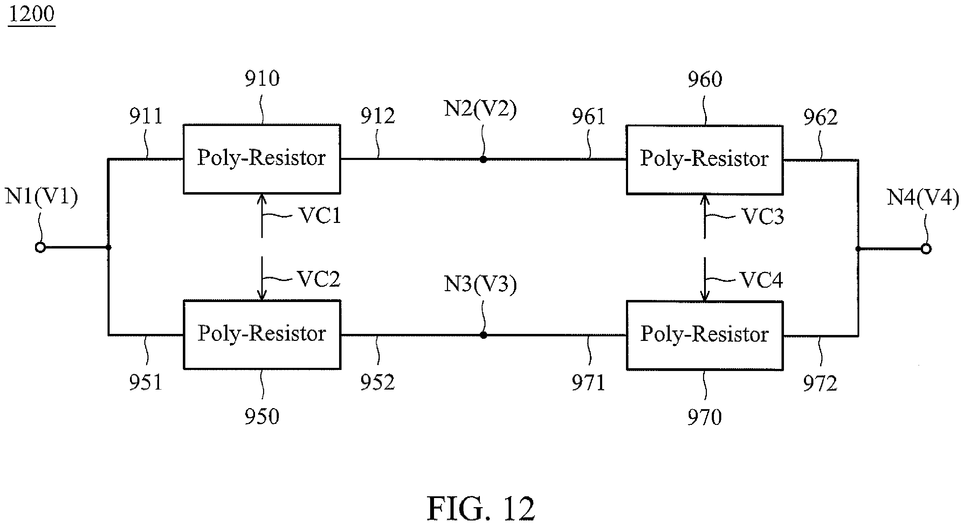

FIG. 12 is a diagram of an impedance circuit 1200 according to another embodiment of the invention. In the embodiment of FIG. 12, the impedance circuit 1200 includes a first poly-resistor 910, a second poly-resistor 950, a third poly-resistor 960, and a fourth poly-resistor 970. In some embodiments, the first poly-resistor 910, the second poly-resistor 950, the third poly-resistor 960, and the fourth poly-resistor 970 have identical structures. In alternative embodiments, the first poly-resistor 910, the second poly-resistor 950, the third poly-resistor 960, and the fourth poly-resistor 970 have different structures but the same resistances. The first poly-resistor 910 has a first terminal 911 and a second terminal 912. The second poly-resistor 950 has a first terminal 951 and a second terminal 952. The third poly-resistor 960 has a first terminal 961 and a second terminal 962. The fourth poly-resistor 970 has a first terminal 971 and a second terminal 972. The first poly-resistor 910 and the third poly-resistor 960 are coupled in series. The second poly-resistor 950 and the fourth poly-resistor 970 are coupled in series. A cascading combination of the first poly-resistor 910 and the third poly-resistor 960 are coupled in parallel with another cascading combination of the second poly-resistor 950 and the fourth poly-resistor 970. Specifically, the first terminal 911 of the first poly-resistor 910 and the first terminal 951 of the second poly-resistor 950 are both coupled to a first node N1; the second terminal 912 of the first poly-resistor 910 and the first terminal 961 of the third poly-resistor 960 are both coupled to a second node N2; the second terminal 952 of the second poly-resistor 950 and the first terminal 971 of the fourth poly-resistor 970 are both coupled to a third node N3; the second terminal 962 of the third poly-resistor 960 and the second terminal 972 of the fourth poly-resistor 970 are both coupled to a fourth node N4. The first node N1 and the fourth node N4 may be considered as I/O (Input/Output) nodes of the impedance circuit 1200. If a fourth voltage V4 at the fourth node N4 is higher than a first voltage V1 at the first node N1 (i.e., a driving voltage difference (V4-V1) is applied to the impedance circuit 1200), a current through the first poly-resistor 910, the second poly-resistor 950, the third poly-resistor 960, and the fourth poly-resistor 970 will flow from the fourth node N4 to the first node N1. The resistance between the first terminal 911 and the second terminal 912 of the first poly-resistor 910 is determined according to a first control voltage VC1. The resistance between the first terminal 951 and the second terminal 952 of the second poly-resistor 950 is determined according to a second control voltage VC2. The resistance between the first terminal 961 and the second terminal 962 of the third poly-resistor 960 is determined according to a third control voltage VC3. The resistance between the first terminal 971 and the second terminal 972 of the fourth poly-resistor 970 is determined according to a fourth control voltage VC4. In one embodiment, the first control voltage VC1, the second control voltage VC2, the third control voltage VC3, and the fourth control voltage VC4 are different from each other. In some embodiments, each of the first poly-resistor 910, the second poly resistor 950, the third poly-resistor 960, and the fourth poly-resistor 970 includes a similar structure to that described in the embodiment of FIG. 3, FIG. 4, or FIG. 10, and it will not be illustrated again here.

In some embodiments, each of the first control voltage VC1, the second control voltage VC2, the third control voltage VC3, and the fourth control voltage VC4 is a function of the first voltage V1 at the first node N1, the second voltage V2 at the second node N2, the third voltage V3 at the third node N3, and the fourth voltage V4 at the fourth node N4. The aforementioned functions may be linear and expressed as the following equations (8) to (11):

$$VC1 = h3(V1,V2,V3,V4) = A1 \cdot V1 + B1 \cdot V2 + C1 \cdot V3 + D1 \cdot V4 \ldots\ldots(8)$$

$$VC2 = k3(V1,V2,V3,V4) = A2 \cdot V1 + B2 \cdot V2 + C2 \cdot V3 + D2 \cdot V4 \ldots\ldots(9)$$

$$VC3 = h4(V1,V2,V3,V4) = A3 \cdot V1 + B3 \cdot V2 + C3 \cdot V3 + D3 \cdot V4 \ldots\ldots(10)$$

$$VC4 = k4(V1,V2,V3,V4) = A4 \cdot V1 + B4 \cdot V2 + C4 \cdot V3 + D4 \cdot V4 \ldots\ldots(11)$$

where "VC1" represents the first control voltage VC1, "VC2" represents the second control voltage VC2, "VC3" represents the third control voltage VC3, "VC4" represents the fourth control voltage VC4, "V1" represents the first voltage V1, "V2" represents the second voltage V2, "V3" represents the third voltage V3, "V4" represents the fourth voltage V4, and each of "A1", "A2", "A3", "A4", "B1", "B2", "B3", B4", "C1", "C2", "C3", "C4", "D1", "D2", "D3", and "D4" represents a respective value.

In some embodiments, the first control voltage VC1, the second control voltage VC2, the third control voltage VC3, and the fourth control voltage VC4 are generated and determined by a controller (not shown) according to the first voltage V1, the second voltage V2, the third voltage V3, and the fourth voltage V4, but they are not limited thereto. In alternative embodiments, any of the first control voltage VC1, the second control voltage VC2, the third control voltage VC3, and the fourth control voltage VC4 is tied together with the first voltage V1, the second voltage V2, the third voltage V3, or the fourth voltage V4, and no controller is required.

The above values A1, A2, A3, A4, B1, B2, B3, B4, C1, C2, C3, C4, D1, D2, D3, and D4 are adjustable in response to different requirements. In some embodiments, the first control voltage VC1 is substantially equal to the first voltage V1, the second control voltage VC2 is substantially equal to the third voltage V3, the third control voltage VC3 is substantially equal to the second voltage V2, and the fourth control voltage VC4 is substantially equal to the fourth voltage V4. Adjustments may be made such that the first control voltage VC1 is substantially equal to the second voltage V2, the second control voltage VC2 is substantially equal to the first voltage V1, the third control voltage VC3 is substantially equal to the fourth voltage V4, and the fourth control voltage VC4 is substantially equal to the third voltage V3. In alternative embodiments, the first control voltage VC1, the second control voltage VC2, the third control voltage VC3, and the fourth control voltage VC4 depend on only the first voltage V1 and the fourth voltage V4. That is, the values B1, B2, B3, B4, C1, C2, C3, and C4 are all set to 0. Other features of the impedance circuit 1200 of FIG. 12 are similar to those of the impedance circuits 900 and 1000 of FIGS. 9 and 10. Accordingly, these embodiments can achieve similar levels of performance.

It should be understood that the proposed impedance circuits 900, 1000, 1100, and 1200 can be applied to a variety of circuits as described in the embodiments of FIGS. 6-8. That is, each poly-resistor shown in the embodiments of FIGS. 6-8 may be replaced with a respective impedance circuit 900, 1000, 1100, or 1200.

The invention proposes a novel impedance circuit and poly-resistors coupled in parallel therein. Such a design can cancel the non-ideal depletion effect of the poly resistors. Alternatively, each poly-resistor may be further divided into a plurality of sub-poly-resistors coupled in series, without affecting the performance of the proposed impedance circuit. To be brief, the proposed impedance circuit can eliminate the depletion effect of the poly-resistors, and make the poly-resistors be more linear and subject to Ohm's law.

Note that the above voltages, currents, resistances, inductances, capacitances and other element parameters are not limitations of the invention. A designer can adjust these parameters according to different requirements. The impedance circuit and poly-resistors of the invention are not limited to the configurations of FIGS. 1-12. The invention may merely include any one or more features of any one or more embodiments of FIGS. 1-12. In other words, not all of the features displayed in the figures should be implemented in the impedance circuit and poly-resistors of the invention.

Use of ordinal terms such as "first", "second", "third", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

**Claims**

1. An impedance circuit (100, 500A, 500B, 900, 1000, 1100, 1200), comprising:

    a first poly-resistor (510, 910, 1010), wherein the first poly-resistor has a first terminal (511, 911, 1011) coupled to a first node (N1), and a second terminal (512, 912, 1012) coupled to a second node (N2); and
    a second poly-resistor (530, 950, 1050), wherein the second poly-resistor has a first terminal (531, 951, 1051) coupled to the first node, and a second terminal (532, 952, 1052) coupled to the second node;
    wherein a resistance between the first terminal and the second terminal of the first poly-resistor is determined according to a first control voltage;
    wherein a resistance between the first terminal and the second terminal of the second poly-resistor is determined according to a second control voltage;
    wherein the first control voltage and the second control voltage are determined according to a first voltage at the first node and a second voltage at the second node.

2. The impedance circuit as claimed in claim 1, wherein each of the first control voltage and the second control voltage is a linear function of the first voltage and the second voltage.

3. The impedance circuit as claimed in claim 1, wherein the first control voltage is substantially equal to the first voltage, and the second control voltage is substantially equal to the second voltage.

4. The impedance circuit as claimed in any one of the preceding claims, wherein the first poly-resistor (510, 910, 1010) comprises:

    a first poly-silicon layer (1020), having a first end and a second end, wherein the first end of the first poly-silicon layer is coupled to the first node, and the second end of the first poly-silicon layer is coupled to the second node;
    a first channel layer (1030), having a first end and a second end, wherein the first end of the first channel layer is arranged for receiving the first control voltage; and
    a first insulation layer (1040), disposed between the first poly-silicon layer and the first channel layer.

5. The impedance circuit as claimed in claim 4, wherein the first end of the first channel layer (1030) is close to the first end of the first poly-silicon layer (1020), and the second end of the first channel layer is close to the second end of the first poly-silicon layer.

6. The impedance circuit as claimed in claim 4 or claim 5, wherein the second poly-resistor comprises:

a second poly-silicon layer, having a first end and a second end, wherein the first end of the second poly-silicon layer is coupled to the first node, and the second end of the second poly-silicon layer (1060) is coupled to the second node;
a second channel layer (1070), having a first end and a second end, wherein the second end of the second channel layer is arranged for receiving the second control voltage; and
a second insulation layer (1080), disposed between the second poly-silicon layer and the second channel layer.

7. The impedance circuit as claimed in claim 6, wherein the first end of the second channel layer is close to the first end of the second poly-silicon layer, and the second end of the second channel layer is close to the second end of the second poly-silicon layer.

8. The impedance circuit as claimed in claim 6 or claim 7, wherein each of the first channel layer and the second channel layer is a conductive layer, a semiconductor layer, or another poly-silicon layer.

9. The impedance circuit as claimed in any one of claims 6 to 8, wherein each of the first insulation layer and the second insulation layer is a silicon dioxide layer, a field oxide (FOX) layer, or a shallow trench isolation (STI) layer.

10. The impedance circuit as claimed in any one of the preceding claims, further comprising:

a third poly-resistor (960), wherein the third poly-resistor has a first terminal coupled to the second node, and a second terminal coupled to a third node; and
a fourth poly-resistor (970), wherein the fourth poly-resistor has a first terminal coupled to the second node, and a second terminal coupled to the third node;
wherein a resistance between the first terminal and the second terminal of the third poly-resistor is determined according to a third control voltage;
wherein a resistance between the first terminal and the second terminal of the fourth poly-resistor is determined according to a fourth control voltage;
wherein the third control voltage and the fourth control voltage are determined according to the second voltage at the second node and a third voltage at the third node.

11. The impedance circuit as claimed in claim 10, wherein each of the third control voltage and the fourth control voltage is a linear function of the second voltage and the third voltage.

12. The impedance circuit as claimed in claim 10, wherein the third control voltage is substantially equal to the second voltage, and the fourth control voltage is substantially equal to the third voltage.

13. The impedance circuit as claimed in any one of the preceding claims, wherein the impedance circuit is a feedback resistor.

14. The impedance circuit as claimed in any one of claims 1 to 12, wherein the impedance circuit is a common-mode feedback resistor.

15. The impedance circuit as claimed in any one of the preceding claims, wherein the impedance circuit is used in a differential or a pseudo-differential amplifier, a differential-to-single-ended amplifier, or an inverting amplifier.

<u>100</u>

FIG. 1

<u>210</u>

FIG. 2

310

211(V1)  212(V2)

VC1  220  340  VC2

331  221  222  332

342  342

N+  N+

N-type Doped Layer

330

P-type Doped Layer  350

# FIG. 3

410

211(V1)  212(V2)

VC1  220  440  VC2

431  221  222  432

442  442

P+  P+

P-type Doped Layer

430

N-type Doped Layer  450

# FIG. 4

500A

510    530

511(V1)    512(V2)    532(V3)

| | |
|Poly-Resistor| |Poly-Resistor|

531

VC1    VC2  VC3    VC4

Controller    520

## FIG. 5A

500B

510    530

511(V1)    512(V2)    531(V3)    532(V4)

| | |
|Poly-Resistor| |Poly-Resistor|

VC1    VC2    VC3    VC4

Controller    550    Controller    560

## FIG. 5B

FIG. 6A

FIG. 6B

FIG. 6C

FIG. 6D

700A

FIG. 7A

700B

FIG. 7B

<u>700C</u>

VC1    VC2

Poly-Resistor    510

IIN

VOP

550

Controller

VIPX

610

IIP

VC3    VC4

560

530    Poly-Resistor    Controller

VSS

## FIG. 7C

<u>700D</u>

VC1    VC2

Poly-Resistor    510

IIN

VOP

550

Controller

VIPX

IIP

VC3    VC4

560

530    Poly-Resistor    Controller

VSS

## FIG. 7D

800A

VC1    VC2

Poly-Resistor — 110

120

VIN  R1                    VOP

Controller

− +

+ — 610

VCM

# FIG. 8A

800B

VC1    VC2

Poly-Resistor — 110

120

IIN                        VOP

Controller

− +

+ — 610

VCM

# FIG. 8B

FIG. 8C

<u>900</u>

910

911                                        912

N1(V1)                                          N2(V2)

| Poly-Resistor |
VC1

VC2

| Poly-Resistor |

951                                        952

950

# FIG. 9

1000

N1(V1)    1011    1012

1020

VC1  1021

1031

1040    Poly-Silicon Layer    1022

1032

Insulation Layer    1040

1010

Channel Layer    1030

1040

1051    1052    N2(V2)

1060

1061    VC2

1071    Poly-Silicon Layer    1062    1072

1080    Insulation Layer    1080

1050

Channel Layer    1070

1080

# FIG. 10

1100

FIG. 11

EP 3 451 398 A1

FIG. 12

EP 3 451 398 A1

Europäisches
Patentamt

European
Patent Office

Office européen
des brevets

# EUROPEAN SEARCH REPORT

Application Number

EP 18 17 7526

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 685 435 B2 (ALPHA & OMEGA SEMICONDUCTOR [US]) 20 June 2017 (2017-06-20) * column 2, line 59 - column 5, line 63; figures 2E,3A-3D,4A-4C * | 1,4-10 | INV. H01L49/02 H03F3/45 H03F1/32 |
| A | GB 1 431 199 A (SONY CORP) 7 April 1976 (1976-04-07) * page 1, line 28 - page 3, line 33; figure 1 * | 1,4-10 | |
| A | US 8 878 334 B1 (RATNAKUMAR ALBERT [US] ET AL) 4 November 2014 (2014-11-04) * column 4, line 19 - column 6, line 10; figures 3,7 * * column 6, line 54 - column 7, line 6 * | 1,4-10 | |
| A | US 2010/109775 A1 (KAMAKURA MASAOMI [JP] ET AL) 6 May 2010 (2010-05-06) * paragraphs [0060] - [0174]; figures 1-29 * | 1,4-10 | |
| A | US 5 027 081 A (BAUM JEFFERY I [US]) 25 June 1991 (1991-06-25) * column 2, lines 5-45; figure 1 * * column 3, lines 5-22 * | 1,4-10 | TECHNICAL FIELDS SEARCHED (IPC)<br>H01L H03F |
| A,P | EP 3 309 850 A2 (MEDIATEK INC [TW]) 18 April 2018 (2018-04-18) * the whole document * | 1,4-10 | |
| E | US 2018/233499 A1 (WEN SUNG-HAN [TW] ET AL) 16 August 2018 (2018-08-16) * the whole document * | 1,4-10 | |

The present search report has been drawn up for all claims

| Place of search | Date of completion of the search | Examiner |
|---|---|---|
| Munich | 23 November 2018 | Ley, Marc |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 3 451 398 A1

## ANNEX TO THE EUROPEAN SEARCH REPORT
## ON EUROPEAN PATENT APPLICATION NO.

EP 18 17 7526

This annex lists the patent family members relating to the patent documents cited in the above-mentioned European search report.
The members are as contained in the European Patent Office EDP file on
The European Patent Office is in no way liable for these particulars which are merely given for the purpose of information.

23-11-2018

| Patent document cited in search report | | Publication date | Patent family member(s) | | Publication date |
|---|---|---|---|---|---|
| US 9685435 | B2 | 20-06-2017 | CN 104052458 A<br>TW 201436459 A<br>US 2014252494 A1<br>US 2016118380 A1<br>US 2017287903 A1 | | 17-09-2014<br>16-09-2014<br>11-09-2014<br>28-04-2016<br>05-10-2017 |
| GB 1431199 | A | 07-04-1976 | AT 354518 B<br>CA 999061 A<br>DE 2323471 A1<br>FR 2184815 A1<br>GB 1431199 A<br>IT 989208 B<br>NL 7306701 A | | 10-01-1979<br>26-10-1976<br>29-11-1973<br>28-12-1973<br>07-04-1976<br>20-05-1975<br>15-11-1973 |
| US 8878334 | B1 | 04-11-2014 | NONE | | |
| US 2010109775 | A1 | 06-05-2010 | JP 2010109233 A<br>US 2010109775 A1 | | 13-05-2010<br>06-05-2010 |
| US 5027081 | A | 25-06-1991 | DE 69120345 D1<br>DE 69120345 T2<br>EP 0454972 A2<br>JP 3095025 B2<br>JP H04229707 A<br>US 5027081 A | | 25-07-1996<br>02-01-1997<br>06-11-1991<br>03-10-2000<br>19-08-1992<br>25-06-1991 |
| EP 3309850 | A2 | 18-04-2018 | CN 107947757 A<br>EP 3309850 A2<br>TW 201815061 A<br>US 2018102404 A1 | | 20-04-2018<br>18-04-2018<br>16-04-2018<br>12-04-2018 |
| US 2018233499 | A1 | 16-08-2018 | NONE | | |

EPO FORM P0459

For more details about this annex : see Official Journal of the European Patent Office, No. 12/82

28